# EUROPÄISCHE PATENTSCHRIFT

(11) **EP 2 828 672 B1**
(45) Veröffentlichungstag und Bekanntmachung des Hinweises auf die Patenterteilung: **13.01.2016**
(21) Anmeldenummer: 13706462.2
(22) Anmeldetag: 18.02.2013
(51) Int. Cl.: G01R 1/20, G01R 31/36

(54) **ELEKTRONISCHER BATTERIESENSOR**
ELECTRONIC BATTERY SENSOR
CAPTEUR ÉLECTRONIQUE POUR BATTERIE

(30) Priorität: 22.03.2012 DE 102012204627
(43) Veröffentlichungstag der Anmeldung: 28.01.2015
(73) Patentinhaber: Robert Bosch GmbH, 70442 Stuttgart (DE)
(72) Erfinder: DOLLANSKY, Matthias, 71701 Schwieberdingen (DE); SCHIMMEL, Chris, 71332 Waiblingen (DE); MUELLER, Michael, 71277 Rutesheim (DE)
(86) Internationale Anmeldenummer: PCT/EP2013/053211
(87) Internationale Veröffentlichungsnummer: WO 2013/139547

(56) Entgegenhaltungen:
- DE-A1- 10 118 027
- DE-A1-102005 032 227
- DE-A1-102005 041 881
- DE-A1-102008 041 539
- DE-A1-102009 000 225
- DE-A1-102009 007 104
- DE-B3- 10 332 410
- FR-A1- 2 881 276
- FR-A1- 2 903 498

## Beschreibung

Die vorliegende Erfindung betrifft einen elektronischen Batteriesensor sowie einen Shuntwiderstand zum Einsatz in einem elektronischen Batteriesensor. Ferner wird ein entsprechendes Verfahren zur Bereitstellung eines elektronischen Batteriesensors bereitgestellt.

### Stand der Technik

Insbesondere im Winter zählen Ausfälle durch Entladen oder vorzeitig gealterte Batterien nach wie vor zu den häufigsten Fehlerursachen. Eine immer größer werdende Anzahl von elektronischen Funktionen in einem Kraftfahrzeug, wie bspw. Sitz- oder Standheizung oder DVD-Player, und deren gleichzeitiger Betrieb erfordern ein gut entwickeltes Batterie- bzw. Energiemanagement. Ein wichtiger Teil eines derartigen Batteriemanagements ist ein elektronischer Batteriesensor, der in regelmäßigen Abständen Spannung, Stromstärke und Temperatur in der Nähe einer entsprechenden Kraftfahrzeugbatterie genau erfasst. Dabei werden die Daten, anders wie bei anderen Sensoren, nicht an ein Steuergerät weitergegeben, sondern von einem in dem Batteriesensor integrierten Steuergerät verarbeitet. Dadurch können ein Zustand einer Batterie erkannt und Fragen, bspw. "wie wird die Restladung z. B. am nächsten Morgen sein?", "wie wird die Spannung am nächsten Morgen sein?" oder "wie haben sich Kapazität und Leistung im Laufe der Zeit entwickelt?" beantwortet werden. Entsprechende Auswertungen werden als Signal an ein Bordnetz des jeweiligen Kraftfahrzeugs weitergegeben, so dass von einem dort ansässigen Bordnetzsteuergerät weitere Aktionen, wie bspw. Abschalten des Motors bei Stillstand an der Ampel, durchgeführt werden können.

Mit Hilfe eines elektronischen Batteriesensors werden demnach Spannung und Strom (über einen Shuntwiderstand) und Temperatur in der Regel permanent gemessen und gespeichert, d. h. auch in Ruhephasen der jeweiligen Batterie. Damit ist nicht nur eine Restladung der Batterie bekannt, sondern aus Erfahrungswerten vergangener Motorstarts auch eine Anforderung an einen Energiespeicher. Auch können derzeitige und frühere Werte verglichen werden, so dass Erkenntnisse über eine Alterung und mögliche Restlebensdauer einer Batterie möglich sind. Durch das Vorsehen eines Batteriesensors ist es möglich, dass das den Batteriesensor umfassende Batteriemanagementsystem in kritischen Zonen rechtzeitig vorsieht, nicht unbedingt nötige Funktionen, wie bspw. eine zweite Stufe einer Heckscheibenheizung oder einer Frontscheibe bereits abzuschalten, wenn sich die Batterie einem kritischen Zustand auch nur nähert.

Aus der DE 10 2009 007104 A1 sind bereits eine Ausführung eines Strommessmoduls und ein Verfahren zur Herstellung eines Batteriesensors bekannt. Das Strommessmodul ist als hohlzylindrischer Messwiderstand ausgeführt. In diesem ist die erforderliche Elektronik mit Schaltungsträger untergebracht und mindestens an zwei Stellen von innen bzw. an den Anschlüssen des hohlzylindrischen Messwiderstands kontaktiert.

Da der Batteriesensor an einer Batterie anzuordnen ist und dort wünschenswerterweise möglichst platzsparend und unauffällig platziert werden sollte, war es nunmehr eine Aufgabe der vorliegenden Erfindung, einen elektronischen Batteriesensor vorzusehen, der einfach aufgebaut und platzsparend an einer Kraftfahrzeugbatterie möglichst vollständig integriert werden kann.

### Offenbarung der Erfindung

Vor dem Hintergrund des Standes der Technik und der voranstehend genannten Aufgabe stellt die Erfindung nunmehr einen elektronischen Batteriesensor mit den Merkmalen von Patentanspruch 1, einen Shuntwiderstand mit den Merkmalen von Patentanspruch 9 sowie ein Verfahren zur Bereitstellung eines elektronischen Batteriesensors mit den Merkmalen von Patentanspruch 11 bereit.

Erfindungsgemäß wird ein elektronischer Batteriesensor zur Zustandserkennung einer Batterie bereitgestellt. Der erfindungsgemäß vorgestellte elektronische Batteriesensor umfasst einen Shuntwiderstand und eine Leiterplatte mit einer Messschaltung, wobei der Shuntwiderstand als Hülse ausgebildet ist, die in ein Durchgangsloch in der Leiterplatte eingesteckt und mit der Leiterplatte verlötet ist.

Der in die Leiterplatte bzw. durch ein Durchgangsloch der Leiterplatte eingesteckte und damit in der Leiterplatte integrierte Shuntwiderstand weist ferner eine erste Auflagefläche für einen Kabelschuh und eine zweite Auflagefläche für eine Polklemme einer zu prüfenden Batterie auf. Dabei sind die erste Auflagefläche und die zweite Auflagefläche relativ zu der Leiterplatte auf verschiedenen Seiten der Leiterplatte angeordnet. Der Shuntwiderstand, der mit der Leiterplatte verlötet ist, wird unter Aussparung der ersten Auflagefläche und der zweiten Auflagefläche von einem Moldmaterial umhüllt, so dass der elektronische Batteriesensor mit Ausnahme der ersten Auflagefläche und der zweiten Auflagefläche nach außen isoliert ist.

Der als Hülse realisierte Shuntwiderstand, der erfindungsgemäß in ein Durchgangsloch der Leiterplatte eingesteckt ist, wird in möglicher Ausgestaltung zur Verbindung einer auf die erste Auflagefläche aufzulegenden Polklemme und eines auf die zweite Auflagefläche aufzulegenden Kabelschuhs von einem Verbindungselement durchdrungen, wobei es sich bei dem Verbindungselement bspw. um eine Schraube handeln kann, die eine Realisierung einer Verbindung zwischen Kabelschuh und Polklemme ermöglicht. Um den Shuntwiderstand gegen die Schraube isolieren zu können, sind in der Hülse Durchgangsöffnungen vorgesehen, durch welche bei einem zur Herstellung einer den elektronischen Batteriesensor generell umschließenden Moldhülle vorgesehenen Moldingprozess Moldmasse hindurch dringt, so dass der Innenraum der Hülse mit Ausnahme der hindurch gesteckten Schraube ebenfalls mit Moldmasse ausgefüllt wird, so dass die Schraube gegen die sie umgebende Hülse isoliert ist. Damit auch kein elektrischer Kontakt zwischen Polklemme und Kabelschuh durch die Schraube realisiert wird, ist in der Polklemme in der Regel ein Kunststoff- oder Keramikeinlass vorgesehen, in welchen die Schraube einzuführen ist, so dass kein elektrischer Kontakt entstehen kann.

Gemäß einer möglichen Ausführungsform besteht die Hülse aus drei miteinander verbundenen Teilhülsen, wobei zwei Teilhülsen aus Kupfer als erste Kupferhülse und als zweite Kupferhülse und eine Teilhülse aus einem Widerstandsmaterial, wie bspw. aus Manganin gefertigt sind. Die Teilhülsen können durch unterschiedliche Verbindungsmöglichkeiten zusammengefügt werden. Dabei können die Teilhülsen bspw. miteinander verlötet, hart- oder weichverlötet sein, zusammengeschweißt, verschraubt oder verklebt sein. Die so gefertigte Hülse wird durch die Leiterplatte bzw. durch das darin vorgesehene Durchgangsloch durchgesteckt, so dass auf beiden Seiten der Leiterplatte eine Auflagefläche jeweils noch übersteht, auf welcher die Polklemme bzw. der Kabelschuh aufzulegen sind. Sodann wird die Hülse an geeigneten Punkten mit der Leiterplatte verlötet. Das Verlöten der Hülse mit der Leiterplatte erlaubt einen elektrischen Kontakt, welcher wiederum einen zu messenden Stromfluss ermöglicht.

Gemäß einer möglichen Ausgestaltung sind die drei Teilhülsen in der Reihenfolge erste Kupferhülse, Manganinhülse und zweite Kupferhülse miteinander verbunden. Bei der ersten Kupferhülse kann es sich um eine Hülse aus Kupfer handeln, wobei deren Höhe sich an der Höhe bzw. Größe von auf der Leiterplatte angeordneten Bauteilen zuzüglich der Wanddicke des Moldmaterials und etwa 0,4 mm Überstand der Kupferhülse orientiert, um einen Kontakt zur Polklemme gewährleisten zu können. Die Wanddicke des Moldmaterials ist in etwa auf 1 bis 1,5 mm zu schätzen. Die Maße, d. h. insbesondere die Höhe der sich daran anschließenden, mit der ersten Kupferhülse verbundenen Hülse aus einem geeigneten Widerstandsmaterial, wie bspw. Manganin, bestimmen sich nach einem erforderlichen elektrischen Widerstand, wobei ein Widerstandswert von 100 µOhm +/- 10 % nicht überstiegen werden sollte. Die zweite Kupferhülse, die sich an die Manganinhülse anschließt, ist in ihrer Höhe lediglich so zu wählen, dass ein Überstand der Kupferhülse aus der Moldmasse gewährleistet werden kann, um über die zweite Auflagefläche einen elektrischen Kontakt zu einem aufzulegenden Kabelschuh zu gewährleisten. Gemäß einer möglichen Ausführungsform verfügt die zweite Kupferhülse über sogenannte Füßchen, die dazu dienen, einen elektrischen Kontakt zu der Leiterplatte herzustellen und quasi parallel zu der aus der Leiterplatte herausragenden Manganinhülse zurück zur Leiterplatte geführt werden, wobei ein Kontakt zwischen diesen Kupferfüßchen zu der Manganinhülse zu verhindern ist, was letztlich durch die Moldmasse realisiert werden kann, welche den gesamten Batteriesensor umschließt und demnach auch zwischen Kupferfüßchen und Manganinhülse eindringen kann.

Diese drei Hülsen bzw. Teilhülsen werden, wie voranstehend bereits erwähnt, verliersicher miteinander verbunden. Dabei kann ein derartiges Verbinden durch Hart- oder Weichlöten, durch Schweißen oder Verkleben realisiert werden. Diese so hergestellte Hülse als Shuntwiderstand wird dann in die Leiterplatte eingepresst bzw. durch das darin vorgesehene Durchgangsloch hindurch gesteckt, bis die Füße der zweiten Kupferhülse die Leiterplatte berühren und dort mit der Leiterplatte verlötet werden. Ferner wird auch die erste Kupferhülse durch Lötpads an der Leiterplatte angelötet. Dabei ist sicherzustellen, wie voranstehend bereits erwähnt, dass die zweite Kupferhülse, insbesondere deren mit der Leiterplatte in Kontakt stehenden Füßchen, nicht mit der Manganinhülse in Kontakt kommen. Dies wird durch das Einfließen von Moldmaterial erzielt. Das Moldmaterial dient dabei als Isolator.

In Ausgestaltung des erfindungsgemäßen elektronischen Batteriesensors dient die Manganinhülse als Beispiel einer Hülse aus einem Widerstandsmaterial als Messbrücke.

Dabei kann die Manganinhülse bei Durchführen der Hülse durch das Durchgangsloch in der Leiterplatte im Durchgangsloch der Leiterplatte angeordnet und somit in der Leiterplatte integriert sein, während die erste Kupferhülse und die zweite Kupferhülse aus der Leiterplatte an jeweils verschiedenen Seiten herausragen und letztlich den elektrischen Kontakt zum Kabelschuh bzw. zur Polklemme realisieren. Um einen elektrischen Kontakt mit der Leiterplatte herzustellen ist es dabei möglich, dass die erste Kupferhülse über Lötpads auf der Unterseite der Leiterplatte angelötet ist und die zweite Kupferhülse über die an ihr vorgesehenen Füßchen an der Oberseite der Leiterplatte angelötet ist, so dass hierüber eine Widerstandsmessung vor Manganin und nach Manganin vorgenommen werden kann. Alternativ ist es jedoch auch denkbar, dass die erste Kupferhülse und die zweite Kupferhülse bezüglich ihrer Form gleich ausgestaltet sind und jeweils an der Oberseite bzw. Unterseite der Leiterplatte aus dieser herausragen und entsprechende Auflagen für den Kabelschuh bzw. die Polklemme bilden, wobei die Manganinhülse dann mittig angeordnet ist und zum Großteil innerhalb des Durchgangslochs der Leiterplatte zum Liegen kommt und hierüber über Bonden direkt mit der Leiterplatte auf deren Oberseite und Unterseite elektrisch verbunden ist.

Gemäß einer weiteren Ausführungsform ist es auch denkbar, dass die als Messbrücke dienende Manganinhülse zwischen Polklemme und Leiterplatte angeordnet und in dem Durchgangsloch der Leiterplatte die Kupferhülse angeordnet ist, welche auf der anderen Seite in Richtung Kabelschuh wieder aus der Leiterplatte herausragt. Die zweite Kupferhülse ist ebenfalls zwischen Polklemme und Leiterplatte angeordnet, wobei zwischen erster Kupferhülse und zweiter Kupferhülse über die Leiterplatte kein elektrischer Kontakt bestehen darf, sondern hier ein Isolatormaterial vorzusehen ist, um den elektrischen Kontakt zu vermeiden. Bei dem Isolatormaterial kann es sich dabei um ein Basismaterial der Leiterplatte, um einen Kleber bzw. Silikon oder allgemein um einen nicht leitenden Kunststoff, wie ein Thermoplast, Duroplast oder ein Elastomer, handeln.

Ferner betrifft die vorliegende Erfindung einen Shuntwiderstand, der als Hülse ausgebildet ist, die in ein Durchgangsloch in eine Leiterplatte einzustecken und mit der Leiterplatte zu verlöten ist. Dabei weist die Hülse eine erste Auflagefläche für eine Polklemme einer Batterie und eine zweite Auflagefläche für einen Kabelschuh auf.

Die Erfindung betrifft insbesondere einen Shuntwiderstand, der in einem voranstehend beschriebenen elektronischen Batteriesensor vorzusehen ist.

Ferner betrifft die vorliegende Erfindung ein Verfahren zur Bereitstellung eines elektronischen Batteriesensors zur Zustandserkennung einer Batterie, bei dem ein Shuntwiderstand und eine Leiterplatte mit einer Messschaltung bereitgestellt werden, wobei der Shuntwiderstand als Hülse ausgebildet wird, die in ein Durchgangsloch in der Leiterplatte eingesteckt und mit der Leiterplatte verlötet wird.

Gemäß einer möglichen Ausgestaltungsform des erfindungsgemäßen Verfahrens wird durch die Hülse ein Verbindungselement zur Verbindung eines Kabelschuhs mit einer Polklemme der Batterie durchgeführt und das Verbindungselement gegen die Hülse mittels einer durch in der Hülse vorgesehene Durchgangslöcher einzuführenden Moldmasse isoliert.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Kurze Beschreibung der Zeichnungen
- Figur 1: zeigt in Figur 1a eine Aufsicht, in Figur 1 b eine Seitenansicht und in Figur 1 c eine weitere Aufsicht einer Ausführungsform eines erfindungsgemäßen elektronischen Batteriesensors.
- Figur 2: zeigt in Seitenansicht eine weitere Ausführungsform eines erfindungsgemäßen elektronischen Batteriesensors.
- Figur 3: zeigt in Seitenansicht eine andere Ausführungsform eines erfindungsgemäßen elektronischen Batteriesensors.

### Ausführungsformen der Erfindung

Die Erfindung ist anhand von Ausführungsformen in den Zeichnungen schematisch dargestellt und wird nachfolgend unter Bezugnahme auf die Zeichnungen schematisch beschrieben.

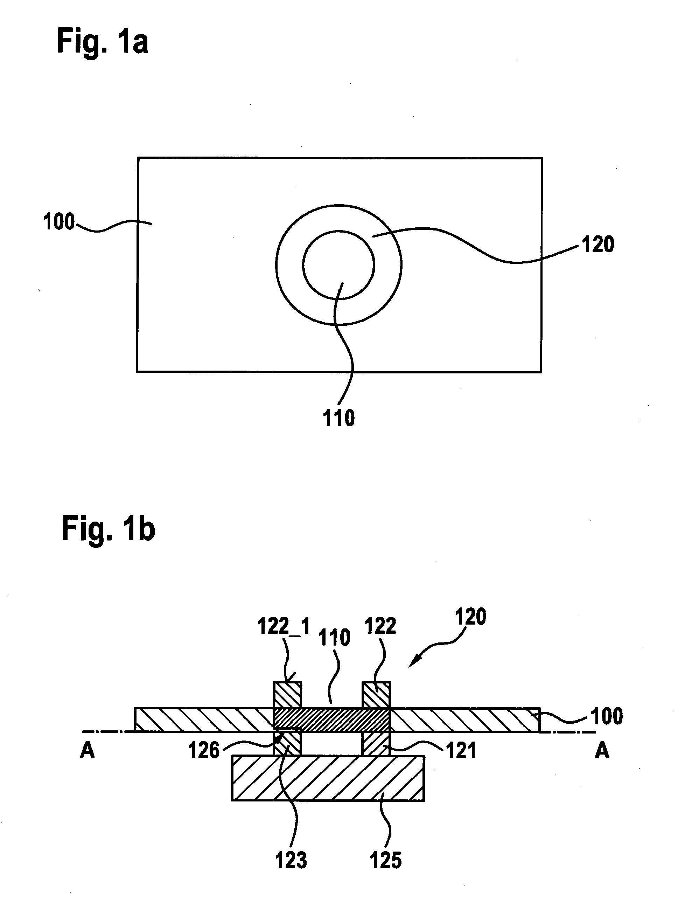

Figur 1a zeigt in Aufsicht eine Leiterplatte 100 mit einem Durchgangsloch 110, in welchem ein als Hülse ausgebildeter Shuntwiderstand 120 eingefügt ist.

In der hier gezeigten Aufsicht auf die Leiterplatte 100 ist als Teilhülse des als Hülse ausgebildeten Shuntwiderstands 120 lediglich eine erste Kupferhülse zu erkennen.

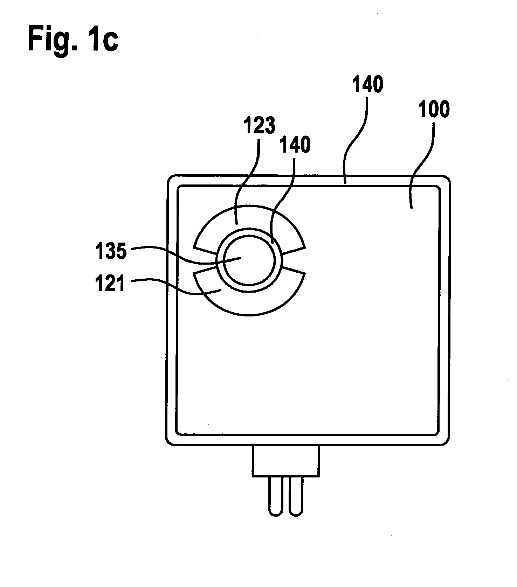

Figur 1 b zeigt nunmehr in schematischer Ansicht eine Schnittansicht durch die Leiterplatte 100. Der Shuntwiderstand 120 besteht als Hülse aus drei Teilhülsen, nämlich einer als Messbrücke dienenden Hülse 121 eines geeigneten Widerstandsmaterials, im Folgenden beispielhaft Manganin, einer ersten Kupferhülse 122 und einer zweiten Kupferhülse 123. Durch das Durchgangsloch 110 der Leiterplatte 100 ist der Shuntwiderstand 120 nunmehr so hindurchgeführt, dass die erste Kupferhülse 122 in diesem Durchgangsloch angeordnet und ferner in Richtung eines hier nicht gezeigten Kabelschuhs aus der Leiterplatte herausragt. Die erste Kupferhülse 122 realisiert somit eine Auflagefläche 122_1 zur Auflage eines Kabelschuhs. Zwischen einer Polklemme 125 und der Leiterplatte 100 ist nunmehr die Manganinhülse 121, welche als Messbrücke fungiert, angeordnet. Zwischen Polklemme und Leiterplatte 100 ist ferner die zweite Kupferhülse 123 angeordnet, um hier für ein gleichmäßiges Verspannen des Sensors zwischen Polklemme und hier nicht gezeigtem Kabelschuh zu realisieren. Um jedoch einen elektrischen Kontakt zwischen Kupferhülse 122 und Kupferhülse 123 zu vermeiden, ist in dem Durchgangsloch 110 ein Isolatormaterial zwischen Kupferhülse 122 und Kupferhülse 123 vorgesehen, welches einen elektrischen Kontakt vermeidet. Dieses Isolatormaterial 126 kann aus Basismaterial der Leiterplatte 100 bestehen, ein Kleber bzw. ein Silikon sein oder ein nichtleitender Kunststoff wie bspw. ein Thermoplast, ein Duroplast oder ein Elastomer. Um eine Messbrücke realisieren zu können, ist die Verbindung zwischen Polklemme 125 und Leiterplatte 100 hier so realisiert, dass die Manganinhülse 121 lediglich umfänglich nur einen Teil des Gesamtumfangs des Durchgangsloches 110 ausfüllt und somit nur eine teilumfängliche Hülse darstellt, während die zweite Kupferhülse 123 ebenfalls umfänglich nur einen Teil des Durchgangsloches beaufschlagt, wobei zwischen Kupferhülse 123 und Manganinhülse 121 ebenfalls kein elektrischer Kontakt bestehen darf, sondern hier ein Isolatormaterial zur Vervollständigung der umlaufenden Hülse vorgesehen ist. Somit stellt die Manganinhülse 121 wie in dem hier dargestellten Ausführungsbeispiel lediglich eine Art Schale/Teilschale dar, welche nur teilweise das Durchgangsloch umfänglich von innen berührt. Sowohl die Dicke der Manganinhülse bzw. -schale 121 wie auch die Breite und Höhe hängen von dem erforderlichen bereitzustellenden Widerstand ab, welcher benötigt wird, um eine funktionale Messbrücke bereitstellen zu können. Die zweite Kupferhülse 123 dient hierbei lediglich als weitere Abstützung zwischen Polklemme 125 und Leiterplatte 100. Um einen Strom messen zu können, ist die erste Kupferhülse 122, welche mit der Manganinhülse 121 verbunden ist, mit der Leiterplatte 100 verlötet.

Figur 1c zeigt eine weitere Aufsicht auf die Leiterplatte 100, wobei hier eine Aufsicht entlang Linie A-A aus Figur 1 b gezeigt ist. Ferner ist in der hier gezeigten Aufsicht bereits ein Moldingprozess durchgeführt, so dass der Shuntwiderstand von einer Moldmasse 140 umgeben ist. In Durchgangsloch 110 ist ferner ein Verbindungselement 135 angeordnet, welches eine Verbindung zwischen einem hier nicht gezeigten Kabelschuh und einer hier nicht gezeigten Polklemme dargestellt. Das Verbindungselement 135, welches bspw. als Schraube realisiert sein kann, ist gegen die Innenwandung der Hülse durch eine Moldmasse 140 isoliert, welche beim Moldingprozess auch zwischen das Verbindungselement 135 und Innenwandung der Hülse einfließen kann. In der hier gezeigten Aufsicht, welche durch Schnitt entlang Linie A-A aus Figur 1 b erstellt wurde, ist die Manganinhülse 121 und die zweite Kupferhülse 123 erkennbar. Dabei sind weder die Manganinhülse 121 noch die Kupferhülse 123 als durchgehende Hülsen, d. h. umlaufend, realisiert, sondern quasi als Teilschalen hergestellt, wobei zwischen ihnen, d. h. an den jeweiligen Verbindungsflächen, ein isolierender Übergang vorgesehen ist, so dass kein elektrischer Kontakt besteht. Ferner steht die hier nicht gezeigte Kupferhülse 122, welche mit der Manganinhülse 121 verbunden ist, nicht in direktem Kontakt mit der zweiten Kupferhülse 123, sondern ist dazu auch durch ein Isolatormaterial getrennt. Nur dadurch kann eine aussagekräftige Strommessung über die als Messbrücke dienende Manganinhülse 121 realisiert werden.

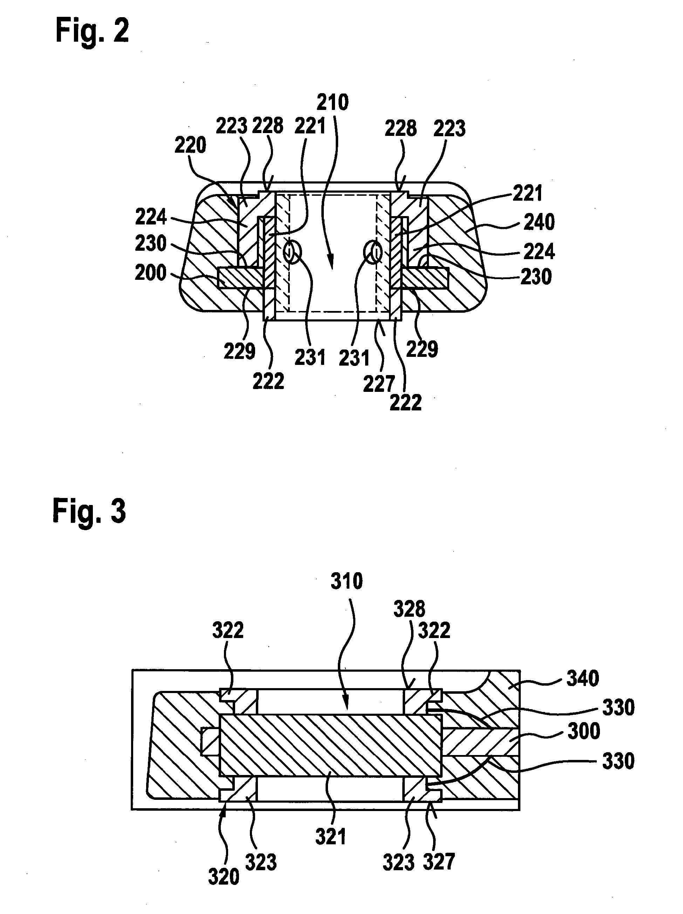

Figur 2 zeigt eine Seitenansicht einer weiteren Ausführungsform eines erfindungsgemäßen elektronischen Batteriesensors. Gezeigt ist eine Leiterplatte 200, welche mit einem Durchgangsloch 210 ausgestattet ist. Durch das Durchgangsloch 210 ist ein Shuntwiderstand 220 durchgesteckt. Der Shuntwiderstand 220 besteht aus drei Teilhülsen, nämlich einer ersten Kupferhülse 222, einer zweiten Kupferhülse 223 und einer Hülse eines Widerstandsmaterials, wie bspw. einer Manganinhülse 221. Die zweite Kupferhülse 223 schließt sich an die in dem Durchgangsloch angeordnete und darüber hinausstehende Manganinhülse 221 an und weist Kupferfüßchen 224 auf, welche quasi parallel zu der Außenwandung der Manganinhülse 221 wieder zurück zur Leiterplatte 200 geführt sind, wo sie mit der Leiterplatte 200 verlötet sind und Lötpads 230 realisieren und somit einen elektrischen Kontakt herstellen. Die Kupferhülse 222 ist ebenfalls über Lötpads 229 mit der Leiterplatte 200 elektrisch verbunden. Die Manganinhülse 221 weist an ihrer Wandung Durchgangslöcher 231 auf, welche es ermöglichen, dass bei einem durchzuführenden Moldingprozess Moldmasse 240 auch in den Innenraum der Hülse einfließen kann. Die Moldmasse 240 realisiert ferner eine Isolierung zwischen den Kupferfüßchen 224 der Kupferhülse 223 und der Manganinhülse 221, so dass hier kein elektrischer Kontakt zwischen den Teilhülsen möglich ist. Die Moldmasse 240 umschließt den elektrischen Batteriesensor derart, dass er vollständig umhüllt ist und lediglich an Auflagefläche 228 und Auflagefläche 227 der Kupferhülse 223 bzw. 222 eine Auflage für eine Polklemme bzw. einen Kabelschuh möglich ist, so dass diese in elektrischen Kontakt mit dem Shuntwiderstand 220 und darüber mit der Leiterplatte 200 treten können. Zur Verbindung einer Polklemme, welche bspw. auf die Auflagefläche 227 aufzulegen ist und eines Kabelschuhs, welcher bspw. auf die Auflagefläche 228 aufzulegen ist, ist oftmals ein Verbindungselement bspw. in Form einer Schraube vorzusehen, welche durch die den Shuntwiderstand 220 realisierenden Hülsen eingesteckt wird und mit einer Mutter verschraubt wird. Um hierbei einen elektrischen Kontakt zwischen der Schraube als Verbindungselement zwischen Polklemme und Kabelschuh und der Innenwandung der Hülsen zu vermeiden, wird durch die vormals genannten Durchgangslöcher 231 an der Innenwandung der Hülse ermöglicht, dass beim Moldingprozess Moldmasse einfließt, so dass die Schraube bzw. allgemein das Verbindungselement zwischen Polklemme und Kabelschuh gegen die Innenwandung der Hülsen isoliert ist. Um auch einen elektrischen Kontakt auf Seiten der Polklemme durch das Verbindungselement zu vermeiden, ist an der Polklemme in der Regel ein Keramik- oder zumindest ein Isoliermaterial vorgesehen, in welches die Schraube einzustecken ist.

Figur 3 zeigt in Seitenansicht eine weitere Ausführungsform eines erfindungsgemäßen elektronischen Batteriesensors. Die Leiterplatte 300 weist wiederum eine Durchgangsöffnung 310 auf, durch welche der als Hülse ausgebildete Shuntwiderstand 320 durchgeführt und eingesteckt ist. Der hier gezeigte Shuntwiderstand 320 besteht wiederum aus drei Teilhülsen, nämlich einer ersten Kupferhülse 322 und einer zweiten Kupferhülse 323 sowie einer Hülse eines geeigneten Widerstandsmaterials, wie bspw. Manganin 321. In der hier dargestellten Ausführungsform sind die Kupferhülsen 322 und 323 gleichartig geformt und ragen zu beiden Seiten aus der Leiterplatte 300 heraus. Die Manganinhülse 321 ist zentral zwischen den Kupferhülsen 322 und 323 angeordnet und mit ihnen jeweils verbunden. Die Manganinhülse 321 ist ferner zentral in dem Durchgangsloch 310 der Leiterplatte 300 angeordnet und ragt zu beiden Seiten aus dieser Durchgangsöffnung 310 heraus. Ein elektrischer Kontakt zur Leiterplatte 300 ist in der hier gezeigten Ausführungsform nicht über Lötpads durch die Kupferhülsen auf der Leiterplatte realisiert, sondern durch eine direkte Anbindung 330 der Manganinhülse 321 durch Bonden an die Leiterplatte 300. Wiederum ist der hier gezeigte elektronische Batteriesensor mit einer Moldmasse umhüllt, welche ein Moldgehäuse 340 bildet. Um wiederum einen Kontakt zu einer Polklemme und einem Kabelschuh herstellen zu können, stellen die Kupferhülse 322 und die Kupferhülse 323 jeweilige Auflageflächen bereit, welche aus dem Moldgehäuse 340 herausragen.

## Patentansprüche

1. Elektronischer Batteriesensor zur Zustandserkennung einer Batterie, mit einem Shuntwiderstand (120, 220, 320) und einer Leiterplatte (100, 200, 300) mit einer Messschaltung, wobei der Shuntwiderstand (120, 220, 320) als Hülse ausgebildet ist, **dadurch gekennzeichnet, dass** die Hülse in ein Durchgangsloch (110, 210, 310) in der Leiterplatte (100, 200, 300) eingesteckt und mit der Leiterplatte (100, 200, 300) verlötet ist.

2. Elektronischer Batteriesensor nach Anspruch 1, bei dem die Hülse aus drei miteinander verbundenen Teilhülsen besteht, wobei zwei Teilhülsen aus Kupfer als erste Kupferhülse (122, 222, 322) und als zweite Kupferhülse (123, 223, 323) und eine Teilhülse aus einem Widerstandsmaterial (121, 221, 321), insbesondere Manganin gefertigt sind.

3. Elektronischer Batteriesensor nach Anspruch 2, bei dem die drei Teilhülsen in der Reihenfolge erste Kupferhülse (122, 222, 322), Widerstandsmaterialhülse, insbesondere Manganinhülse (121, 221, 321) und zweite Kupferhülse (123, 223, 323) miteinander verbunden sind.

4. Elektronischer Batteriesensor nach einem der Ansprüche 2 oder 3, bei dem die Widerstandsmaterialhülse, insbesondere die Manganinhülse (121, 221, 321) als Messbrücke dient.

5. Elektronischer Batteriesensor nach einem der Ansprüche 2 bis 4, bei dem die Wiederstandsmaterialhülse, insbesondere die Manganinhülse (321) im Durchgangsloch (310) der Leiterplatte (300) angeordnet und somit in der Leiterplatte (300) integriert ist.

6. Elektronischer Batteriesensor nach einem der Ansprüche 2 bis 4, bei dem die erste Kupferhülse (122) im Durchgangsloch (110) der Leiterplatte (100) angeordnet und somit in der Leiterplatte (100) integriert ist.

7. Elektronischer Batteriesensor nach einem der Ansprüche 2 bis 6, bei dem die erste und die zweite Kupferhülse (222, 223) jeweils durch Lötpads (229, 230) mit der Leiterplatte (200) elektrisch verbunden sind.

8. Elektronischer Batteriesensor nach einem der Ansprüche 2 bis 7, bei dem die Widerstandsmaterialhülse, insbesondere die Manganinhülse (321) über Bonden mit der Leiterplatte (300) elektrisch verbunden ist.

9. Shuntwiderstand, der als Hülse ausgebildet ist, **dadurch gekennzeichnet, dass** die Hülse in ein Durchgangsloch (110, 210, 310) in einer Leiterplatte (100, 200, 300) einzustecken und mit der Leiterplatte (100, 200, 300) zu verlöten ist, wobei die Hülse eine erste Auflagefläche für eine Polklemme einer Batterie und eine zweite Auflagefläche für einen Kabelschuh aufweist.

10. Shuntwiderstand, der in einem elektronischen Batteriesensor nach einem der Ansprüche 1 bis 8 vorzusehen ist.

11. Verfahren zur Bereitstellung eines elektronischen Batteriesensors zur Zustandserkennung einer Batterie, bei dem ein Shuntwiderstand und eine Leiterplatte mit einer Messschaltung bereit gestellt werden, wobei der Shuntwiderstand als Hülse ausgebildet wird, **dadurch gekennzeichnet, dass** die Hülse in ein Durchgangsloch in der Leiterplatte eingesteckt und mit der Leiterplatte verlötet wird.

12. Verfahren nach Anspruch 11, bei dem durch die Hülse ein Verbindungselement zur Verbindung eines Kabelschuhs mit einer Polklemme der Batterie durchgeführt und das Verbindungselement gegen die Hülse mittels einer durch in der Hülse vorgesehene Durchgangslöcher einzuführenden Moldmasse isoliert wird.

## Claims

1. Electronic battery sensor for detecting the state of a battery, having a shunt resistor (120, 220, 320) and a printed circuit board (100, 200, 300) with a measuring circuit, wherein the shunt resistor (120, 220, 320) is formed as a sleeve, **characterized in that** the sleeve is inserted in a through-hole (110, 210, 310) in the printed circuit board (100, 200, 300) and is soldered to the printed circuit board (100, 200, 300).

2. Electronic battery sensor according to Claim 1, in which the sleeve consists of three part-sleeves that are connected to one another, wherein two part-sleeves are produced from copper as a first copper sleeve (122, 222, 322) and a second copper sleeve (123, 223, 323) and one part-sleeve is produced from a resistance material (121, 221, 321), in particular Manganin.

3. Electronic battery sensor according to Claim 2, in which the three part-sleeves are connected to one another in the sequence of the first copper sleeve (122, 222, 322), the resistance-material sleeve, in particular Manganin sleeve (121, 221, 321), and the second copper sleeve (123, 223, 323).

4. Electronic battery sensor according to either of Claims 2 and 3, in which the resistance-material sleeve, in particular the Manganin sleeve (121, 221, 321), serves as a measuring bridge.

5. Electronic battery sensor according to one of Claims 2 to 4, in which the resistance-material sleeve, in particular the Manganin sleeve (321), is arranged in the through-hole (310) in the printed circuit board (300) and is consequently integrated in the printed circuit board (300).

6. Electronic battery sensor according to one of Claims 2 to 4, in which the first copper sleeve (122) is arranged in the through-hole (110) in the printed circuit board (100) and is consequently integrated in the printed circuit board (100).

7. Electronic battery sensor according to one of Claims 2 to 6, in which the first and the second copper sleeve (222, 223) are respectively electrically connected to the printed circuit board (200) by solder pads (229, 230).

8. Electronic battery sensor according to one of Claims 2 to 7, in which the resistance-material sleeve, in particular the Manganin sleeve (321), is electrically connected to the printed circuit board (300) by bonding.

9. Shunt resistor, which is formed as a sleeve, **characterized in that** the sleeve can be inserted into a through-hole (110, 210, 310) in a printed circuit board (100, 200, 300) and can be soldered to the printed circuit board (100, 200, 300), wherein the sleeve has a first bearing surface for a pole terminal of a battery and a second bearing surface for a cable shoe.

10. Shunt resistor, which can be provided in an electronic battery sensor according to one of Claims 1 to 8.

11. Method for providing an electronic battery sensor for detecting the state of a battery, in which a shunt resistor and a printed circuit board with a measuring circuit are provided, wherein the shunt resistor is formed as a sleeve, **characterized in that** the sleeve is inserted into a through-hole in the printed circuit board and is soldered to the printed circuit board.

12. Method according to Claim 11, in which a connecting element for connecting a cable shoe to a pole terminal of the battery is led through the sleeve and the connecting element is insulated from the sleeve by means of a moulding compound that can be introduced through through-holes provided in the sleeve.

## Revendications

1. Capteur de batterie électronique destiné à identifier l'état d'une batterie, comprenant une résistance shunt (120, 220, 320) et un circuit imprimé (100, 200, 300) doté d'un circuit de mesure, la résistance shunt (120, 220, 320) étant réalisée sous la forme d'une douille, **caractérisé en ce que** la douille est insérée dans un trou traversant (110, 210, 310) dans le circuit imprimé (100, 200, 300) puis brasée au circuit imprimé (100, 200, 300).

2. Capteur de batterie électronique selon la revendication 1, avec lequel la douille se compose de trois douilles partielles assemblées l'une à l'autre, deux douilles partielles étant fabriquées en cuivre en tant que première douille en cuivre (122, 222, 322) et deuxième douille en cuivre (123, 223, 323) et une douille partielle en un matériau résistif (121, 221, 321), notamment de la manganine.

3. Capteur de batterie électronique selon la revendication 2, avec lequel les trois douilles partielles sont assemblées l'une à l'autre selon la séquence première douille en cuivre (122, 222, 322), douille en matériau résistif, notamment douille en manganine (121, 221, 321), et deuxième douille en cuivre (123, 223, 323).

4. Capteur de batterie électronique selon l'une des revendications 2 et 3, avec lequel la douille en matériau résistif, notamment la douille en manganine (121, 221, 321), sert de pont de mesure.

5. Capteur de batterie électronique selon l'une des revendications 2 à 4, avec lequel la douille en matériau résistif, notamment la douille en manganine (321), est disposée dans le trou traversant (310) du circuit imprimé (300) et est ainsi intégrée dans le circuit imprimé (300).

6. Capteur de batterie électronique selon l'une des revendications 2 à 4, avec lequel la première douille en cuivre (122) est disposée dans le trou traversant (110) du circuit imprimé (100) et est ainsi intégrée dans le circuit imprimé (100).

7. Capteur de batterie électronique selon l'une des revendications 2 à 6, avec lequel la première et la deuxième douille en cuivre (222, 223) sont respectivement reliées électriquement au circuit imprimé (200) par des pastilles de brasage (229, 230).

8. Capteur de batterie électronique selon l'une des revendications 2 à 7, avec lequel la douille en matériau résistif, notamment la douille en manganine (321), est reliée électriquement au circuit imprimé (300) par le biais d'une métallisation.

9. Résistance shunt, laquelle est réalisée sous la forme d'une douille, **caractérisée en ce que** la douille est à insérer dans un trou traversant (110, 210, 310) dans le circuit imprimé (100, 200, 300) puis à braser au circuit imprimé (100, 200, 300), la douille possédant une première surface d'appui pour une borne de pôle d'une batterie et une deuxième surface d'appui pour une cosse de câble.

10. Résistance shunt, laquelle est à prévoir dans un capteur de batterie électronique selon l'une des revendications 1 à 8.

11. Procédé de production d'un capteur de batterie électronique destiné à identifier l'état d'une batterie, selon lequel une résistance shunt et un circuit imprimé doté d'un circuit de mesure sont fournis, la résistance shunt étant réalisée sous la forme d'une douille, **caractérisé en ce que** la douille est insérée dans un trou traversant dans le circuit imprimé puis brasée au circuit imprimé.

12. Procédé selon la revendication 11, selon lequel un élément de liaison destiné à relier une cosse de câble à une borne de pôle d'une batterie est passé à travers la douille et l'élément de liaison est isolé par rapport à la douille au moyen d'une masse de moulage à introduire dans des trous traversants prévus dans la douille.
